# EUROPEAN PATENT SPECIFICATION

(11) **EP 3 182 455 B1**
(45) Date of publication and mention of the grant of the patent: **04.09.2019**
(21) Application number: 17151849.1
(22) Date of filing: 07.12.2009
(51) Int. Cl.: H01L 27/148

(54) **IMAGE SENSORS WITH LATERAL OVERFLOW DRAINS**
BILDSENSOREN MIT SEITLICHEN ÜBERLAUF-SENKEN
CAPTEURS D'IMAGE À DRAINS DE TROP-PLEINS LATÉRAUX

(30) Priority: 10.12.2008 US 121249 P; 30.10.2009 US 609257
(43) Date of publication of application: 21.06.2017
(62) Divisional of application: 09798979.2
(73) Proprietor: Semiconductor Components Industries, LLC, Phoenix, AZ 85008 (US)
(72) Inventor: Banghart, Edmund Kenneth, New York, NY 14650 (US); Stevens, Eric Gordon, New York, NY 14650 (US); Doan, Hung Quoc, New York, NY 14650 (US)
(74) Representative: Manitz Finsterwald Patent- und Rechtsanwaltspartnerschaft mbB

(56) References cited:
- EP-A2- 1 289 019
- JP-A- 56 049 577
- US-A- 4 362 575
- US-A- 4 579 626
- US-A- 4 607 429
- US-A- 5 585 298
- US-A1- 2002 140 003
- US-B1- 6 794 219

## Description

### TECHNICAL FIELD

The present invention relates generally to image sensors for use in digital cameras and other types of image capture devices, and more particularly to image sensors having lateral overflow drain and channel stop regions.

### BACKGROUND

A typical electronic image sensor includes a number of photosensitive picture elements ("pixels") arranged in a two-dimensional array. The pixels accumulate charge carriers in response to light striking the pixels, and each pixel has a maximum amount of charge it can store. A phenomenon known as "blooming" occurs when the total number of charge carriers collected by a pixel exceeds the charge capacity for that pixel and the excess charge spills over into adjacent pixels. One known anti-blooming technique forms a lateral overflow drain (LOD) within a pixel to provide a means for draining the excess charge carriers from the pixel before the charge carriers spill into adjacent pixels.

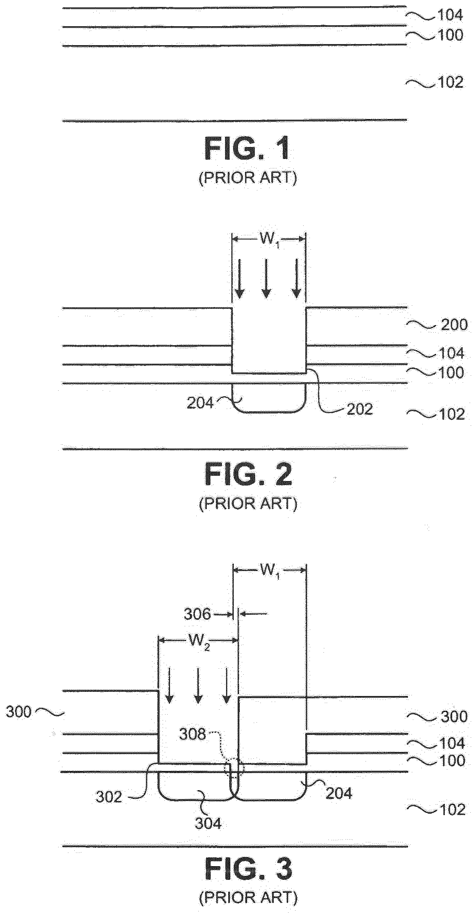

**FIGS. 1-3** depict a method of forming lateral overflow drain and channel stop regions in accordance with the prior art. Initially, as shown in **FIG. 1****,** an insulating layer 100 is formed over a substrate or well 102. A nitride layer 104 is then formed over the insulating layer 100.

**FIG. 2** illustrates mask layer 200 formed on nitride layer 104 and patterned to form an opening having a width W₁. The portion of nitride layer 104 that is exposed in the opening is etched away. Nitride layer 104 is commonly over etched to accommodate for variations in the thickness of nitride layer 104. This overetching removes a portion 202 of insulating layer 100. A dopant is then implanted into substrate 102 (represented by arrows) to form channel stop 204. Channel stop 204 prevents charge carriers from spilling to horizontally adjacent pixels.

Mask layer 200 is then removed and another mask layer 300 is formed on the remaining nitride layer 104 and the exposed portion of insulating layer 100 (FIG. 3). Mask layer 300 is patterned to form an opening having a width W2, and the portion of nitride layer 104 exposed in the second opening is etched away. Again, nitride layer 104 is typically over etched to account for variations in the thickness of nitride layer 104, thereby removing another portion 302 of insulating layer 100. A dopant is then implanted into substrate 102 (represented by arrows) to form lateral overflow drain 304.

To ensure that all of nitride layer 104 that overlies the lateral overflow drain region is removed prior to the formation of the lateral overflow drain 302, W2 typically overlaps with W1, creating overlap area 306. When nitride layer 104 is etched as shown in FIGS. 2 and 3, the portion 308 of insulating layer 100 located in overlap area 306 is etched twice. This double-etching can remove portion 308 completely, thereby exposing the top surface of substrate 102 and allowing the substrate surface to be damaged during subsequent processing steps. Exposing or damaging the top surface of substrate 102 can potentially result in contamination of substrate 102 and produce defects in the image sensor, such as, for example, cluster defects.

### SUMMARY

A lateral overflow drain and a channel stop are fabricated using a double mask layer process according to claim 1.

US 5585298 discloses a self aligned, lateral-overflow drain antiblooming structure. The length of the antiblooming barrier regions are adjusted and determined by photolithography. In this structure, an antiblooming potential barrier is provided that is smaller (in volts) than the barriers that separate the pixels from one another.

### ADVANTAGEOUS EFFECT OF THE INVENTION

It is the object of the present invention to provide an image sensor forming method capable of forming one or more lateral overflow drains without damaging any underlying layers. Additionally, the object of the present invention is to provide accurate and repeatable manufacturing methods for fabricating lateral overflow drains and channel stops with minimal feature sizes.

These objects are accomplished by the features of claim 1.

### BRIEF DESCRIPTION OF THE DRAWINGS

Embodiments of the invention are better understood with reference to the following drawings. The elements of the drawings are not necessarily to scale relative to each other.
FIGS. 1-3 depict a method of forming lateral overflow drain and channel stop regions in accordance with the prior art;
FIG. 4 is a simplified block diagram of an image capture device in an embodiment in accordance with the invention;
FIG. 5 is a simplified block diagram of image sensor 406 shown in FIG. 4 in an embodiment in accordance with the invention; FIG. 6 is a simplified diagram of pixel 500 shown in FIG. 5 in an embodiment in accordance with the invention;
FIGS. 7-12 are cross section views of a portion of pixel 500 along line A-A' in FIG. 6 illustrating a method of forming lateral overflow drain 610 and channel stop 608 in an embodiment in accordance with the invention; and
**FIGS. 13-15** are cross section views of a portion of pixel 500 along line A-A' in FIG. 6 illustrating alternate techniques that can be performed instead of the techniques shown in **FIGS.** 8-10 according to examples being useful to understand the present invention.

### DETAILED DESCRIPTION

Throughout the specification and claims, the following terms take the meanings explicitly associated herein, unless the context clearly dictates otherwise. Directional terms such as "on", "over", "top", "bottom", are used with reference to the orientation of the Figure(s) being described. Because components of embodiments of the present invention can be positioned in a number of different orientations, the directional terminology is used for purposes of illustration only and is in no way limiting. When used in conjunction with layers of an image sensor wafer or corresponding image sensor, the directional terminology is intended to be construed broadly, and therefore should not be interpreted to preclude the presence of one or more intervening layers or other intervening image sensor features or elements. Thus, a given layer that is described herein as being formed on or formed over another layer may be separated from the latter layer by one or more additional layers.

Additionally, the terms "wafer" and "substrate" are to be understood as a semiconductor-based material including, but not limited to, silicon, silicon-on-insulator (SOI) technology, doped and undoped semiconductors, epitaxial layers formed on a semiconductor substrate, and other semiconductor structures.

Referring to the drawings, like numbers indicate like parts throughout the views.

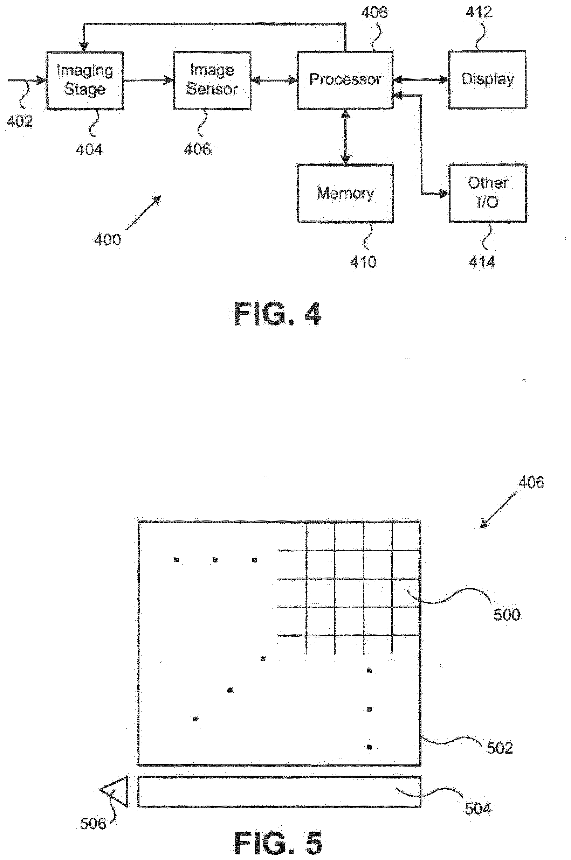

**FIG. 4** is a simplified block diagram of an image capture device in an embodiment in accordance with the invention. Image capture device 400 is implemented as a digital camera in FIG. 4. Those skilled in the art will recognize that a digital camera is only one example of an image capture device that can utilize an image sensor incorporating the present invention. Other types of image capture devices, such as, for example, cell phone cameras, scanners, and digital video camcorders can be used with the present invention.

In digital camera 400, light 402 from a subject scene is input to an imaging stage 404. Imaging stage 404 can include conventional elements such as a lens, a neutral density filter, an iris and a shutter. Light 402 is focused by imaging stage 404 to form an image on image sensor 406. Image sensor 406 captures one or more images by converting the incident light into electrical signals. Digital camera 400 further includes processor 408, memory 410, display 412, and one or more additional input/output (I/O) elements 414. Although shown as separate elements in the embodiment of FIG. 4, imaging stage 404 may be integrated with image sensor 406, and possibly one or more additional elements of digital camera 400, to form a camera module. For example, a processor or a memory may be integrated with image sensor 406 in a camera module in embodiments in accordance with the invention.

Processor 408 may be implemented, for example, as a microprocessor, a central processing unit (CPU), an application-specific integrated circuit (ASIC), a digital signal processor (DSP), or other processing device, or combinations of multiple such devices. Various elements of imaging stage 404 and image sensor 406 may be controlled by timing signals or other signals supplied from processor 408.

Memory 410 may be configured as any type of memory, such as, for example, random access memory (RAM), read-only memory (ROM), Flash memory, disk-based memory, removable memory, or other types of storage elements, in any combination. A given image captured by image sensor 406 may be stored by processor 408 in memory 410 and presented on display 412. Display 412 is typically an active matrix color liquid crystal display (LCD), although other types of displays may be used. The additional I/O elements 414 may include, for example, various on-screen controls, buttons or other user interfaces, network interfaces, or memory card interfaces.

It is to be appreciated that the digital camera shown in **FIG. 4** may comprise additional or alternative elements of a type known to those skilled in the art. Elements not specifically shown or described herein may be selected from those known in the art. As noted previously, the present invention may be implemented in a wide variety of image capture devices. Also, certain aspects of the embodiments described herein may be implemented at least in part in the form of software executed by one or more processing elements of an image capture device. Such software can be implemented in a straightforward manner given the teachings provided herein, as will be appreciated by those skilled in the art.

Referring now to **FIG. 5****,** there is shown a simplified block diagram of image sensor 406 shown in **FIG. 4** in an embodiment in accordance with the invention. Image sensor 406 is implemented as a true two-phase full frame Charge Coupled Device (CCD) image sensor (described later) in **FIG. 4****.** Other embodiments in accordance with the invention are not limited to this type of image sensor. By way of example only, image sensor 406 may be implemented as an interline CCD image sensor, or a three or four phase CCD image sensor in other embodiments in accordance with the invention.

Image sensor 406 includes a number of pixels 500 typically arranged in rows and columns to form an imaging area 502. Each pixel 500 is configured as a shift element with each column of pixels forming a vertical shift register. After an image is captured by pixels 500, the accumulated charges are read out of imaging area 502. During image readout, the vertical shift registers shift each row of accumulated charges or signals out to horizontal shift register 504. Horizontal shift register 504 then sequentially shifts the charges to output amplifier 506.

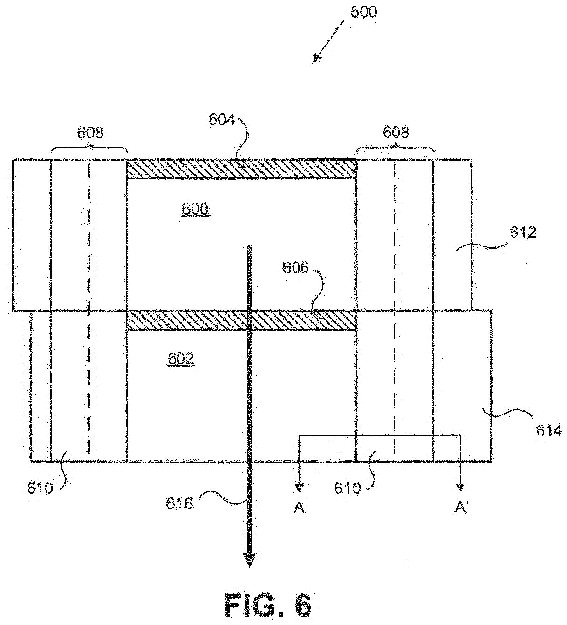

**FIG. 6** is a simplified diagram of pixel 500 shown in **FIG. 5** in an embodiment in accordance with the invention. As discussed earlier, image sensor 406 in **FIG. 5** is implemented as a true two-phase CCD image sensor. When a CCD image sensor includes multiple phases, the vertical CCDs are each separated into multiple parts or "phases" to facilitate the transfer of charge through the structures. Thus, in a true two-phase CCD, each shift element in a vertical CCD has a first phase shift element 600 and a second phase shift element 602.

Barrier regions 604, 606 separate each shift element 600, 602 in pixel 500 from vertically adjacent pixels and facilitate the transfer of charge through the vertical CCD. Channel stop 608 is formed within pixel 500 to prevent charge from spilling to horizontally adjacent pixels. Lateral overflow drain 610 (shown in dashed lines) is formed within channel stop 608, and is used to drain excess or undesirable charge from pixel 500. Lateral overflow drain 610 has a higher dopant concentration than the dopant concentration of channel stop 608 in an embodiment in accordance with the invention.

Overflow barrier regions are also formed in pixel 500. The overflow barrier regions are not shown in **FIG. 6** for the sake of clarity. Overflow barrier regions can be designed and fabricated using any known fabrication method. Overflow barrier regions are described, for example, in United States Patents 5,130,774 and 5,349,215.

And finally, gate electrodes 612, 614 are formed over pixel 500 and are made of a transparent material that allows light to pass through electrodes 612, 614. Examples of a transparent material include, but are not limited to, polysilicon and indium-tin-oxide (ITO). Gate electrodes 612, 614 activate the transfer of charge through shift elements 600, 602. A voltage is alternately applied to each gate electrode 612, 614 to shift charge from one shift element to the next shift element. Arrow 616 indicates the direction of the charge transfer through each vertical shift register.

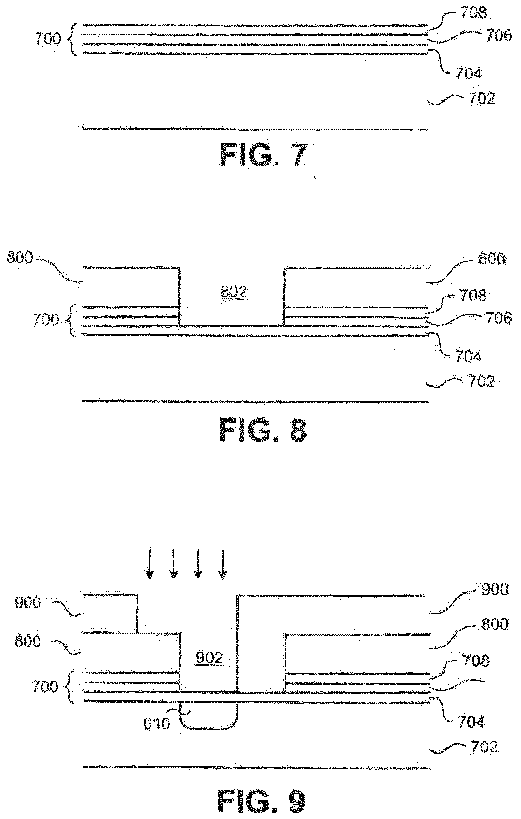

Referring now to **FIGS. 7-12****,** there are shown cross section views of a portion of pixel 500 along line A-A' in **FIG. 6** that illustrate a method of forming lateral overflow drain 610 and channel stop 608 in an embodiment in accordance with the invention. **FIG. 7** depicts a portion of a pixel after a number of initial fabrication steps have been completed. The pixel at this stage includes an insulating layer 700 formed over layer 702. By way of example only, insulating layer 700 is implemented as an oxide-nitride-oxide (ONO) layer (layers 704, 706, and 708, respectively) in an embodiment in accordance with the invention. Layer 702 is configured as a substrate, layer, or well having either an n or p conductivity type.

Hard mask layer 800 is then formed over insulating layer 700 and patterned to form opening 802 **(****FIG. 8****).** By way of example only, hard mask layer 800 can be formed as a silicon nitride or silicon dioxide layer. The portions of oxide layer 708 and nitride layer 706 that are exposed in opening 802 are removed. Oxide layer 704 is not removed and acts as a protection and screening layer in an embodiment in accordance with the invention.

A second mask layer 900 is then formed on hard mask layer 800 and patterned to form opening 902 **(****FIG. 9****).** Second mask layer 900 is formed by depositing a photoresist on hard mask layer 800 in an embodiment in accordance with the invention. Opening 902 resides in a portion of opening 802 with second mask layer 900 filling in the remaining portion of opening 802.

One or more dopants are then implanted into layer 702 (represented by arrows) to form lateral overflow drain 610. The dopant or dopants used to form lateral overflow drain 610 are of the opposite conductivity type from the conductivity type of layer 702. For example, if layer 702 includes p-type dopants, then lateral overflow drain 610 is formed with n-type dopants. Arsenic is an exemplary n-type dopant that can be implanted with a concentration of 1x10¹⁴ atoms per square centimeter to form lateral overflow drain 610.

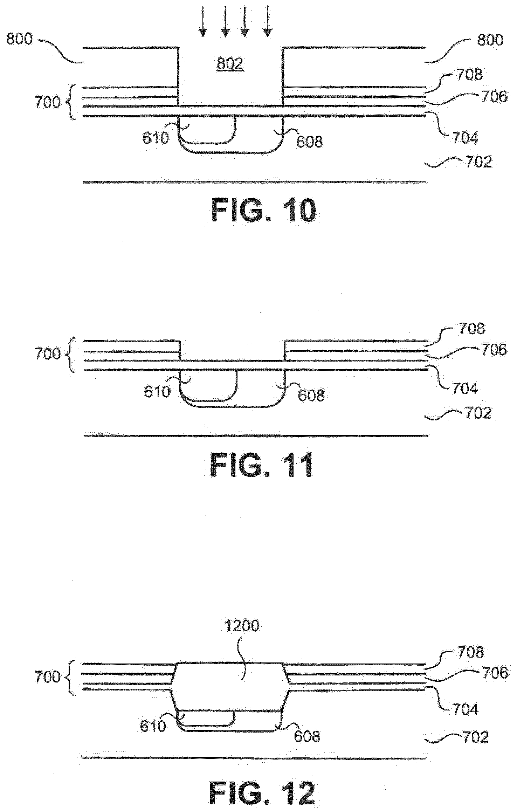

Next, as shown in **FIG. 10****,** mask layer 900 is removed and one or more dopants are implanted (represented by arrows) through opening 802 and into lateral overflow drain 610 and an adjoining portion of layer 702 to form channel stop 608. The one or more dopants used to form channel stop 608 have the same conductivity type as layer 702. For example, if layer 702 has p-type conductivity, the dopant or dopants used to form channel stop 608 are p-type dopants in an embodiment in accordance with the invention. By way of example only, boron is a p-type dopant that can be implanted with a concentration of 1x10¹³ atoms per square centimeter to form channel stop 608.

Due to the use of two mask layers 800 and 900, one edge of lateral overflow drain 610 is aligned, or substantially aligned, with an edge of channel stop 608. Hard mask layer 800 is then removed, resulting in the structure shown in **FIG. 11****.** A field oxide region 1200 is formed over channel stop 608 and lateral overflow drain 610 **(****FIG. 12****).** Field oxide region 1200 can be formed using any known method. Pixel 500 can now be processed further. Subsequent processing steps may include the formation of a buried channel, an overflow barrier region disposed adjacent to lateral overflow drain 610, and an overlying gate electrode.

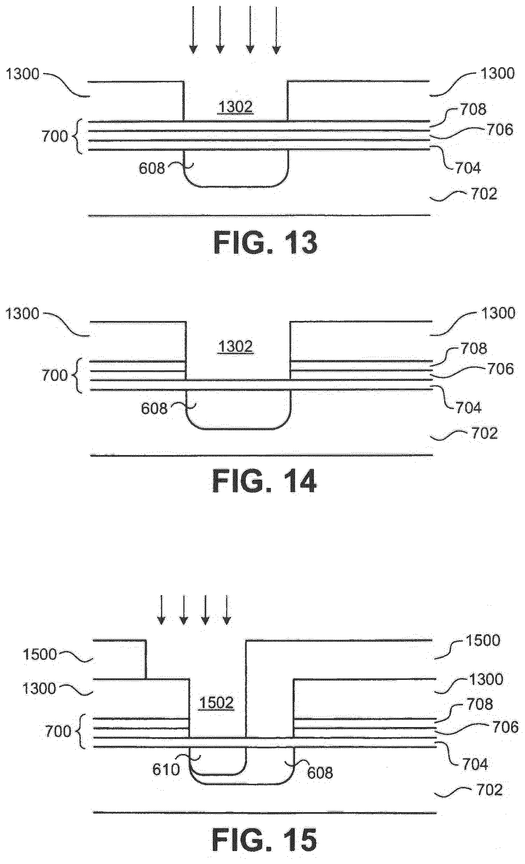

**FIGS. 13-15** are cross section views of a portion of pixel 500 along line A-A' in **FIG. 6** illustrating alternate techniques that can be performed instead of the techniques shown in **FIGS.** 8-10 in an example being useful to understand the present invention.

The processing step shown in **FIG. 13** is performed after **FIG. 7****.** Mask layer 1300 is formed on insulating layer 700 and patterned to create first opening 1302 **(****FIG. 13****).** Mask layer 1300 is formed by depositing a photoresist over insulating layer 700 in an example. In another example, mask layer 1300 is formed by depositing a hard mask layer over insulating layer 700.

One or more dopants are then implanted (represented by arrows) through opening 1302 and into layer 702 to form channel stop 608. The one or more dopants used to form channel stop 608 have the same conductivity type as layer 702. For example, if layer 702 has p-type conductivity, the dopant or dopants used to form channel stop 608 are p-type dopants in an example. Boron is an exemplary p-type dopant that can be implanted with a concentration of 1x10¹³ atoms per square centimeter to form channel stop 608. In another example, one or more n-type dopants can be used to form channel stop 608 when layer 702 has an n-type conductivity.

Next, as shown in **FIG. 14****,** oxide layer 708 and nitride layer 706 that are exposed in opening 1302 are removed. Oxide layer 708 and nitride layer 706 are etched with a plasma etch in an example. Oxide layer 704 is not removed and acts as a protection and screening layer in an example.

Mask layer 1500 is then formed over mask layer 1300 and patterned to create second opening 1502 **(****FIG. 15****).** Mask layer 1500 is formed by depositing a photoresist over mask layer 1300 in an example. Second opening 1502 is disposed in a portion of first opening 1302, and a portion of mask layer 1500 is disposed in the remaining portion of opening 1302.

One or more dopants are then implanted (represented by arrows) through opening 1502 and into channel stop 608 to form lateral overflow drain 610. Due to the dual-mask layers 1300 and 1500, one edge of lateral overflow drain 610 is aligned, or substantially aligned, with an edge of channel stop 608. The dopant or dopants used to form lateral overflow drain 610 are of the opposite conductivity type from channel stop 608. For example, if channel stop 608 includes p-type dopants, then lateral overflow drain 610 is formed with n-type dopants. By way of example only, arsenic is an n-type dopant that can be implanted with a concentration of 1x10¹⁴ atoms per square centimeter to form lateral overflow drain 610.

Mask layer 1500 and mask layer 1300 in **FIG. 15** are removed after lateral overflow drain 610 is formed, resulting in the pixel structure depicted in **FIG. 11****.** Field oxide region 1200 is now formed over channel stop 608 and lateral overflow drain 610, as shown in **FIG. 12****.** Field oxide region 1200 can be formed using any known method. Pixel 500 can now be processed further. Subsequent processing steps may include the formation of a buried channel, an overflow barrier region disposed adjacent to lateral overflow drain 610, and an overlying gate electrode.

Lateral overflow drains 610 and channel stops 608 formed by the methods shown in **FIGS. 7-15** can have smaller dimensions than prior art structures. This is because the sizes of opening 902 in **FIG. 9** and opening 1502 in **FIG. 15** are smaller than the achievable minimum sizes for openings 802 **(****FIG. 8****)** and 1302 **(****FIG. 13****).** When formed using conventional lithography techniques, the smallest dimensions for openings 802 and 1302 are defined and constrained by the minimum dimensions that can be obtained with conventional lithography. But, since openings 902 and 1502 are formed within openings 802 and 1302, respectively, openings 902 and 1502 have smaller dimensions than openings 802 and 1302. Thus, the present invention provides accurate and repeatable methods for fabricating lateral overflow drains and channel stops with minimal feature sizes.

The invention has been described with reference to particular embodiments in accordance with the invention. By way of example only, in an example being useful to understand the present invention the order in which the fabrication steps shown in **FIG. 8** and in **FIGS. 9-10** can be reversed. Thus, oxide layer 708 and nitride layer 706 that are exposed in opening 802 are removed after the formation of lateral overflow drain 610 and channel stop 608. Additionally, the conductivity types of layer 702 and channel stop 608 can be n-type while the conductivity type of lateral overflow drain is p-type.

### PARTS LIST

- 100: insulating layer
- 102: substrate, layer, or well
- 104: nitride layer
- 200: mask layer
- 202: portion of insulating layer
- 204: channel stop
- 300: mask layer
- 302: portion of insulating layer
- 304: lateral overflow drain
- 306: overlap area
- 308: portion of insulating layer
- 400: image capture device
- 402: light
- 404: imaging stage
- 406: image sensor
- 408: processor
- 410: memory
- 412: display
- 414: other input/output (I/O) elements
- 500: pixel
- 502: imaging area
- 504: horizontal shift register
- 506: output amplifier
- 600: shift element
- 602: shift element
- 604: barrier region
- 606: barrier region
- 608: channel stop
- 610: lateral overflow drain
- 612: gate electrode
- 614: gate electrode
- 616: arrow representing direction of charge transfer
- 700: insulating layer
- 702: layer
- 704: oxide layer
- 706: nitride layer
- 708: oxide layer
- 800: hard mask layer
- 802: opening
- 900: second mask layer
- 902: opening
- 1200: field oxide
- 1300: mask layer
- 1302: opening
- 1500: mask layer
- 1502: opening

## Claims

1. A method of forming a CCD image sensor including a lateral overflow drain (610) and a channel stop (608) associated with a pixel of an image sensor, the pixel comprising one or more shift elements (600, 602) for the accumulation of charge carriers in response to exposure to light, the method comprising the following steps in the following order:
forming a first mask layer (800) over an insulating layer (700) disposed on a semiconductor layer (702) of second conductivity type;
removing a portion of the first mask layer (800) and a first portion (706, 708) of the insulating layer (700) disposed below said portion of the first mask layer (800) such that a second portion (704) of the insulating layer (700) remains as protection layer for the surface of the semiconductor layer (702), thereby forming a first opening (802);
forming a second mask layer (900) over the first mask layer (800) and the first opening (802);
removing a portion of the second mask layer (900) to form a second opening (902) disposed within and sharing a boundary with the first opening (802) such that a part of the first opening remains covered by said second mask layer (900);
introducing dopants having a first conductivity type opposite to the second conductivity type into the semiconductor layer (702) through only the second opening (902), thereby forming the lateral overflow drain (610) for draining excess charge carriers from the one or more shift elements;
removing the second mask layer (900), and
introducing dopants having said second conductivity type into the semiconductor layer (702) through the first opening (802), thereby forming the channel stop (608) for preventing movement of charge carriers from the one or more shift elements into a second pixel adjacent to the pixel,
wherein (i) the lateral overflow drain (610) is disposed within and shares a boundary with the channel stop (608) and (ii) the lateral overflow drain (610) is formed before the channel stop (608) is formed.

2. The method of claim 1, further comprising forming a field oxide region (1200) over the channel stop and the lateral overflow drain.

3. The method of claim 1, wherein at least one of (i) the dopants having the first conductivity type or (ii) the dopants having the second conductivity type are introduced into the semiconductor layer through an insulating layer (704) disposed over the semiconductor layer.

4. The method of claim 1, wherein the semiconductor layer comprises a semiconductor-based substrate.

5. The method of claim 1, wherein the first mask layer (800) comprises a hard mask.

6. The method of claim 5, wherein the first mask layer (800) comprises at least one of an oxide layer or a nitride layer.

7. The method of claim 1, wherein the second mask layer (900) comprises photoresist.

8. The method of claim 1, wherein a width of the channel stop (608) is greater than a width of the lateral overflow drain (610).

## Patentansprüche

1. Verfahren zum Ausbilden eines CCD-Bildsensors mit einem seitlichen Überlaufabfluss (610) und mit einem mit einem Pixel eines Bildsensors verbundenen Kanalanschlag (608), wobei das Pixel ein oder mehrere Schiebeelemente (600, 602) zum Ansammeln von Ladungsträgern in Ansprechen darauf, dass sie Licht ausgesetzt sind, umfasst, wobei das Verfahren die folgenden Schritte in der folgenden Reihenfolge umfasst, dass:
eine erste Maskenschicht (800) über einer Isolierschicht (700) ausgebildet wird, die auf einer Halbleiterschicht (702) mit einem zweiten Leitfähigkeitstyp angeordnet ist;
ein Abschnitt der ersten Maskenschicht (800) und ein erster Abschnitt (706, 708) der Isolierschicht (700), der unter dem Abschnitt der ersten Maskenschicht (800) angeordnet ist, entfernt werden, sodass ein zweiter Abschnitt (704) der Isolierschicht (700) als Schutzschicht für die Oberfläche der Halbleiterschicht (702) verbleibt, wodurch eine erste Öffnung (802) ausgebildet wird;
eine zweite Maskenschicht (900) über der ersten Maskenschicht (800) und der ersten Öffnung (802) ausgebildet wird;
ein Abschnitt der zweiten Maskenschicht (900) entfernt wird, um eine zweite Öffnung (902) auszubilden, die in der ersten Öffnung (802) ausgebildet ist und sich eine Begrenzung damit so teilt, dass ein Teil der ersten Öffnung durch die zweite Maskenschicht (900) bedeckt bleibt;
Dotierstoffe mit einem ersten Leitfähigkeitstyp, der dem zweiten Leitfähigkeitstyp entgegengesetzt ist, in die Halbleiterschicht (702) nur durch die zweite Öffnung (902) eingebracht werden, wodurch der seitliche Überlaufabfluss (610) zum Ableiten überschüssiger Ladungsträger aus dem einen oder den mehreren Schiebeelementen ausgebildet wird;
die zweite Maskenschicht (900) entfernt wird, und
Dotierstoffe mit dem zweiten Leitfähigkeitstyp durch die erste Öffnung (802) in die Halbleiterschicht (702) eingebracht werden, wodurch der Kanalanschlag (608) zum Verhindern einer Bewegung von Ladungsträgern von dem einen oder den mehreren Schiebeelementen in ein zweites Pixel benachbart zu dem Pixel ausgebildet wird,
wobei (i) der seitliche Überlaufabfluss (610) in dem Kanalanschlag (608) angeordnet ist und sich mit diesem eine Begrenzung teilt und (ii) der seitliche Überlaufabfluss (610) ausgebildet wird, bevor der Kanalanschlag (608) ausgebildet wird.

2. Verfahren nach Anspruch 1, das ferner umfasst, dass eine Feldoxidregion (1200) über dem Kanalanschlag und dem seitlichen Überlaufabfluss ausgebildet wird.

3. Verfahren nach Anspruch 1, wobei (i) die Dotierstoffe mit dem ersten Leitfähigkeitstyp und/oder (ii) die Dotierstoffe mit dem zweiten Leitfähigkeitstyp durch eine Isolierschicht (704) hindurch, die über der Halbleiterschicht angeordnet ist, in die Halbleiterschicht eingebracht werden.

4. Verfahren nach Anspruch 1, wobei die Halbleiterschicht ein halbleiterbasiertes Substrat umfasst.

5. Verfahren nach Anspruch 1, wobei die erste Maskenschicht (800) eine Hartmaske umfasst.

6. Verfahren nach Anspruch 5, wobei die erste Maskenschicht (800) eine Oxidschicht und/oder eine Nitritschicht umfasst.

7. Verfahren nach Anspruch 1, wobei die zweite Maskenschicht (900) einen Fotolack umfasst.

8. Verfahren nach Anspruch 1, wobei eine Breite des Kanalanschlags (608) größer als eine Breite des seitlichen Überlaufabflusses (610) ist.

## Revendications

1. Procédé de formation d'un capteur d'image CCD incluant un drain d'évacuation de charges (610) et un arrêt de canal (608) associés à un pixel d'un capteur d'image, le pixel comprenant un ou plusieurs éléments de décalage (600, 602) pour l'accumulation de porteurs de charges en réponse à une exposition à la lumière, le procédé comprenant les étapes suivantes dans l'ordre suivant :
formation d'une première couche de masque (800) sur une couche isolante (700) disposée sur une couche semi-conductrice (702) d'un second type de conductivité ;
retrait d'une partie de la première couche de masque (800) et d'une première partie (706, 708) de la couche isolante (700) disposée sous ladite partie de la première couche de masque (800) de sorte qu'une seconde partie (704) de la couche isolante (700) reste comme couche de protection pour la surface de la couche semi-conductrice (702), formant ainsi une première ouverture (802) ;
formation d'une seconde couche de masque (900) sur la première couche de masque (800) et la première ouverture (802) ;
retrait d'une partie de la seconde couche de masque (900) pour former une seconde ouverture (902) disposée à l'intérieur de la première ouverture (802) et partageant une frontière avec celle-ci de sorte qu'une partie de la première ouverture reste couverte par ladite seconde couche de masque (900) ;
introduction de dopants ayant un premier type de conductivité opposé au second type de conductivité dans la couche semi-conductrice (702) à travers seulement la seconde ouverture (902), formant ainsi le drain d'évacuation de charges (610) pour drainer les porteurs de charge en excès desdits un ou plusieurs éléments de décalage ;
retrait de la seconde couche de masque (900) et
introduction de dopants ayant ledit second type de conductivité dans la couche semi-conductrice (702) à travers la première ouverture (802), formant ainsi l'arrêt de canal (608) pour empêcher le mouvement des porteurs de charge depuis lesdits un ou plusieurs éléments de décalage vers un second pixel adjacent au pixel,
dans lequel (i) le drain d'évacuation de charges (610) est disposé à l'intérieur de l'arrêt de canal (608) et partage une frontière avec celui-ci et (ii) le drain d'évacuation de charges (610) est formé avant que l'arrêt de canal (608) soit formé.

2. Procédé selon la revendication 1, comprenant en outre la formation d'une région d'oxyde de champ (1200) au-dessus de l'arrêt de canal et du drain d'évacuation de charges.

3. Procédé selon la revendication 1, dans lequel (i) les dopants ayant le premier type de conductivité et/ou (ii) les dopants ayant le second type de conductivité sont introduits dans la couche semi-conductrice à travers une couche isolante (704) disposée au-dessus de la couche semi-conductrice.

4. Procédé selon la revendication 1, dans lequel la couche semi-conductrice comprend un substrat à base de semi-conducteur.

5. Procédé selon la revendication 1, dans lequel la première couche de masque (800) comprend un masque dur.

6. Procédé selon la revendication 5, dans lequel la première couche de masque (800) comprend au moins une couche parmi une couche d'oxyde et une couche de nitrure.

7. Procédé selon la revendication 1, dans lequel la deuxième couche de masque (900) comprend une résine photosensible.

8. Procédé selon la revendication 1, dans lequel une largeur de l'arrêt de canal (608) est supérieure à une largeur du drain d'évacuation de charges (610).
